(19) Europäisches Patentamt

European Patent Office

Office européen des brevets

(11) **EP 0 880 143 B1**

(12) **EUROPEAN PATENT SPECIFICATION**

(45) Date of publication and mention
of the grant of the patent:
**05.03.2003 Bulletin 2003/10**

(51) Int Cl.⁷: **G11C 16/06**, G11C 16/04

(21) Application number: **98303947.0**

(22) Date of filing: **19.05.1998**

(54) **A non-volatile memory device and method for programming**

Nichtflüchtige Speicheranordnung und Programmierverfahren

Dispositif de mémoire non-volatile et procédé de programmation

(84) Designated Contracting States:
**DE FR GB**

(30) Priority: **19.05.1997 KR 9719239**

(43) Date of publication of application:
**25.11.1998 Bulletin 1998/48**

(73) Proprietor: **Samsung Electronics Co., Ltd.**
**Suwon City, Kyungki-do (KR)**

(72) Inventors:
• **Lee, Dong-Gi**
  **Bundang-ku, Sungnam-shi, Kyunggi-do (KR)**
• **Jung, Tae-Sung**
  **Seocho-ku, Seoul (KR)**

(74) Representative:
**Tunstall, Christopher Stephen et al**
**Harrison Goddard Foote,**
**Fountain Precinct,**
**Leopold Street**
**Sheffield S1 2QD (GB)**

(56) References cited:
**DE-A- 4 422 791**

• **JUNG DAL CHOI ET AL: "A triple polysilicon stacked flash memory cell with wordline self-boosting programming" INTERNATIONAL ELECTRON DEVICES MEETING 1997. IEDM TECHNICAL DIGEST (CAT. NO.97CH36103), INTERNATIONAL ELECTRON DEVICES MEETING. IEDM TECHNICAL DIGEST, WASHINGTON, DC, USA, 7-10 DEC. 1997, pages 283-286, XP002109185 1997, New York, NY, USA, IEEE, USAISBN: 0-7803-4100-7**
• **CHOI J D ET AL: "A NOVEL BOOSTER PLATE TECHNOLOGY IN HIGH DENSITY NAND FLASH MEMORIES FOR VOLTAGE SCALING-DOWN AND ZERO PROGRAM DISTURBANCE" 1996 SYMPOSIUM ON VLSI TECHNOLOGY. DIGEST OF TECHNICAL PAPERS, HONOLULU, JUNE 11 - 13, 1996,11 June 1996 (1996-06-11), page 238/239 XP000639331 INSTITUTE OF ELECTRICAL AND ELECTRONICS ENGINEERSISBN: 0-7803-3343-8**

EP 0 880 143 B1

**EP 0 880 143 B1**

**Description**

**Field of the Invention**

The invention relates to the field of a non-volatile memory device having EEPROM (electrically erasable and programmable read only memory) cells, and more specifically to a flash EEPROM employing booster plates.

**Background of the Invention**

It has been usual that flash EEPROMs (also known as flash memory) typically need high voltages in erasing and programming operations, in which data stored in a memory cell is erased and programmed by a tunnel effect that is induced between a floating gate and a substrate by applying a high voltage to the memory cell. Those high voltage are generally over ten volts, which may hurt thin and weak oxide layers used in isolating the floating gates and substrate, resulting in a degradation of reliability with the memory cell and destruction of the memory cell. It is required to improve the stability of operation of flash memory and to enable erasing and programming operations even with reduced applied voltages.

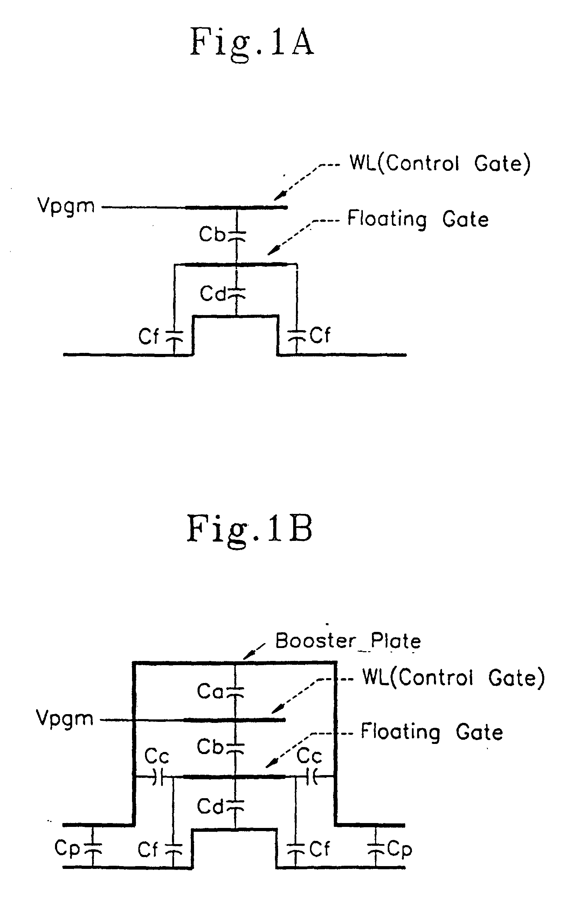

A known technique relies on lowering the high voltages, and is disclosed in an article in 'Symposium of VLSI Technology' of 1996, entitled *A Novel Booster Plate Technology In High Density NAND Flash Memories For Voltage Scaling-Down And Zero Program Disturbance.* The memory cell discussed there is shown in Figure 1B as an equivalent circuit of coupling capacitance. A standard floating gate transistor (or floating gate memory cell) having a control gate, floating gate, source and drain regions is shown in Figure 1A, for comparison. The preamble of claim 1 is based on this disclosure.

In the standard floating gate transistor of Figure 1A, capacitances Cb, Cd and two Cf exist between the control gate and floating gate, between the floating gate and channel region, and between the floating gate and source/drain regions. With that capacitive construction, the voltage at the floating gate, Vfg, is as follows when a programming voltage Vpgm is applied to the control gate WL:

$$Vfg = Vpgm \times Cb/(Cb + Cd + 2Cf) \qquad [1]$$

In programming, charges are injected to the floating gate from the channel region through an intervening oxide layer if the floating gate voltage Vfg is boosted higher than a critical voltage which causes a tunnel effect such as Fowler-Nordheim tunnelling. Such programming increases the threshold voltage of the memory cell. In this example, the ratio of Vfg to Vpgm, i.e. a coupling ratio during a programming operation, γc, is Cb/(Cb+Cd+2Cf).

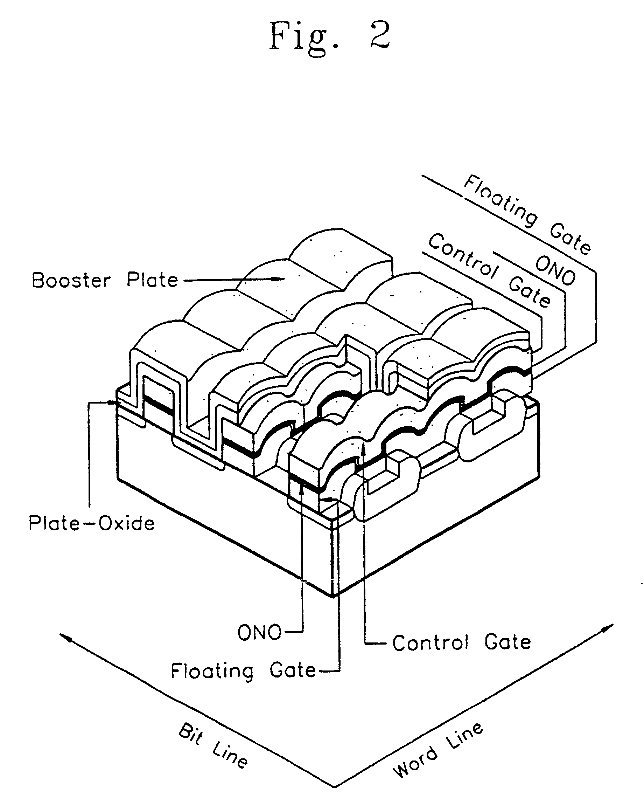

However, as shown in Figures 1A and 2, since the aforementioned article proposes a booster plate which is formed over the control gates with being extended along the direction of word lines and arranged in the direction of bit lines in parallel each other. More coupling capacitances Ca, Cc and Cp, are combined with those capacitances of equation [1]. Capacitances Ca, Cc and Cp are interposed between the booster plate and the control gate, the floating gate and substrate, respectively. As, in programming, the booster plate receives a voltage in addition to the application of Vpgm to the control gate through a word line, the coupling ratios of the floating gate each against the control gate yw and booster plate_γp, become:

$$γw = Cb/(Cb+2Cc+Cd+2Cf); \text{ and } γp =2Cc/(Cb+2Cc+Cd+2Cf).$$

The overall coupling ratio of the floating gate for the Vpgm and booster plate voltage, γc(p), may be summarised into:

$$γc(p) = \frac{(Cb+2Cc)}{(Cb+2Cc+Cd+2Cf)} \cdot \qquad [2]$$

Comparing the equations [1] and [2], the flash memory cell having the booster plate has a greater coupling ratio than that of the standard flash memory cell. The greater coupling ratio enables use of a reduced programming voltage, which means a programming operation could be successfully carried out in a flash memory cell as shown in Figure 1B, even with a Vpgm lower than that of the standard flash memory cell is applied to the control gate of the booster plate memory cell. The larger coupling ratio is useful to accomplish a program inhibit operation for preventing unselected memory cells from being disturbed, by self-boosting unselected word lines, while a selected memory cell is being programmed.

2

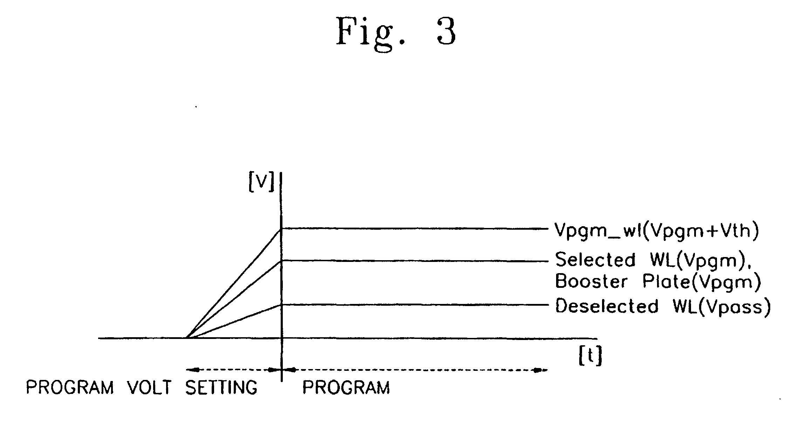

Figure 3 shows configurations of voltages applied to the booster plate memory cell while programming in a NAND-type flash memory. In the voltage setting period, the pass voltage Vpass to be applied to unselected memory cells, the program voltage Vpgm and program transfer voltage Vpgm_wl are linearly increased towards their predetermined potentials. The voltage Vpgm must be applied to a selected word line which is coupled to the control gate and booster plate of a selected memory cell. The applied voltage and therefore must be higher than Vpgm by Vth (threshold voltage of the transfer MOSFET) so as to supply the full value of Vpgm to the selected word line without a voltage drop. Vpass is lower than Vpgm, as usual. If the programming period begins, Vpgm_wl is applied to a gate of transfer transistors corresponding to the selected word line and the booster plate. Vpgm is thereby applied to a selected word line and the booster plate. Vpass is applied to unselected word lines, to supply a bias voltage to drain of the selected memory cell, from a corresponding bit line.

However, some problems are encountered in applying voltages to the booster plate structure. First, although the booster plate contributes to reducing a voltage level of Vpgm, a long time is required for charging or discharging the booster plate while programming, due to its large capacitance, about twenty times that of a word line.

The large capacitance leads to increased current consumption and power dissipation during charging and discharging.

Another problem encountered is leakage current between cell strings (or NAND cell units) sharing the booster plate, which the Vpgm is being connected to. Each booster plate entirely covers several adjacent cell strings. The leakage current may lead to operational instability of the memory.

Furthermore, repeated application of a high booster plate voltage, at every programming cycle, reduces reliability of the insulation layer between the booster plate and the floating gate. This may disable the programming operation or cause a programmed cell to be put in a lightly-erased state, in which the threshold voltage of the programmed cell is changed from a desired profile and approaches a threshold voltage corresponding to an erased state.

It is not desirable to alleviate these problems by lowering the voltage applied to the booster plate, since that would lead to a higher program voltage required for the word lines.

## Summary of the Invention

Accordingly, it is required to improve the reliability of a flash memory with a booster plate.

It is also required to provide a flash memory with a reduced booster plate voltage.

It is also required to provide a flash memory with a booster plate, with reduced power consumption during programming.

It is also required to provide a NAND-type flash memory with a booster plate, with enhanced programming efficiency.

According to a first aspect of the present invention, there is provided a flash memory comprising:

-   an array of memory cells having sources, drains, floating gates and control gates, the array including a conductive plate formed over the memory cells to provide a capacitive coupling between the memory cells and the conductive plate;

-   a first voltage source to supply a first voltage to the control gate of a selected one of the memory cells;

    characterised in that the flash memory further comprises:

-   means for placing the control gates in a floating state after the control gate of the selected one of the memory cells has been charged up to a predetermined potential by the first voltage source; and

-   a second voltage source to supply a second voltage to the conductive plate after the control gates have been placed in a floating state.

Preferably the flash memory of the present invention further comprises a switching circuit to transfer the first voltage to a control gate of the selected one of the memory cells and the second voltage to the conductive plate, in response to a control signal.

Preferably, the flash memory of the present invention further comprises a third voltage source to supply a third voltage (Vpass) to the control gates of unselected memory cells of the memory cells; and a switching circuit to transfer the third voltage to the control gates of the unselected memory cells of the memory cells, in response to control signals. The switching circuit makes the control gates be in a floating state after all of the control gates of the memory cells have been charged up to predetermined potentials but before the second voltage is applied to the conductive plate.

Preferably, the flash memory of the present invention further comprises the array divided into a plurality of

EP 0 880 143 B1

memory blocks, and the second voltage source supplies the second voltage to the conductive plate, in response to a control signal which selects one of the memory blocks.

Preferably, the control signals include a first drive control signal which makes all of the control gates be in a floating state after all of the control gates have been charged up to predetermined potentials and before the second voltage is applied to the conductive plate, and a second drive control signal which connects the second voltage to the conductive plate after said all of the control gates of the memory cells have been charged up to the predetermined potentials.

Preferably, the array is divided into a plurality of memory blocks, the control gates of the memory cells being coupled to word lines. In addition, a plurality of drive lines is connected to the control gates through corresponding transfer transistors; a block decoder controls the transfer transistors; and a section decoder is coupled to the drive lines. The section decoder supplies the first voltage, the second voltage, and further supplies a third voltage for unselected word lines. The second voltage is applied to the conductive plate after the first voltage has been effectively transferred to the selected one of the memory cells through the associated word line.

Preferably, the flash memory of the present invention further comprises a further drive line corresponding to the conductive plate; a switching circuit including a transfer transistor interposed between a drive line and the conductive plate; and a plurality of transfer transistors interposed between corresponding drive lines and word lines. The block decoder is coupled to gates of the transfer transistors of the switching circuit. A first output of the block decoder is coupled to the gate of the transfer transistor connected to the conductive plate so that the second voltage (Vbp) is applied to the conductive plate in response to a control signal which selects one of the memory blocks, after the first and third voltages have been effectively transferred to the selected and unselected word lines. A second output of the block decoder (Vx) is coupled to the gates of the transfer transistors connected to the word lines.

According to a second aspect of the present invention, there is provided a method for operating a flash memory comprising an array of memory cells having sources, drains, floating gates and control gates, the array including a conductive plate formed over the memory cells to provide a capacitive coupling between the memory cells and the conductive plate, and a first voltage source; wherein

- the first voltage source supplies a first voltage to the control gate of a selected one of the memory cells;

    characterised in that:

- the control gates are placed in a floating state after the control gate of the selected one of the memory cells has been charged up to a predetermined potential by the first voltage source; and

- a second voltage source provided in the flash memory supplies a second voltage to the conductive plate after the control gates have been placed in a floating state.

Preferably, the method further comprises transferring the first voltage to a control gate (WL) of the selected one of the memory cells, and transferring the second voltage (Vbp) to the conductive plate, in response to a control signal.

Preferably, the method further comprises supplying a third voltage (Vpass); and transferring the third voltage to the control gates of the unselected memory cells of the memory cells, in response to control signals. The control gates are in a floating state after all of the control gates of the memory cells have been charged up to predetermined potentials and before the second voltage is applied to the conductive plate.

Preferably, the method also includes dividing the array into a plurality of memory blocks, and supplying the second voltage to the conductive plate in response to a control signal which selects one of the memory blocks.

Preferably, the control signals include a first drive control signal which makes all of the control gates be in a floating state after all of the control gates have been charged up to predetermined potentials and before the second voltage is applied to the conductive plate, and a second drive control signal which connects the second voltage to the conductive plate after said all of the control gates of the memory cells have been charged up to the predetermined potentials.

Preferably, the method further comprises dividing the array into a plurality of memory blocks, coupling the control gates of the memory cells to word lines; connecting a plurality of drive lines to the control gates through corresponding transfer transistors and word lines; controlling the transfer transistors with a block decoder; and coupling a section decoder to the drive lines. The section decoder supplies the first voltage, the second voltage, and further supplying a third voltage to unselected word lines. The second voltage is applied to the conductive plate after the first voltage has been effectively transferred to the selected one of the word lines.

Preferably, the method further comprises coupling a further drive line to the conductive plate; providing a switching circuit including a transfer transistor interposed between a corresponding one of the drive lines and the conductive plate and a plurality of transfer transistors interposed between corresponding drive lines and word lines; coupling the block decoder to gates of the transfer transistors of the switching circuit. A first output of the block decoder is coupled to the gate of the transfer transistor connected to the conductive plate, and a second output of the block decoder is coupled to the gates of the transfer transistors connected to the word lines. The second voltage is applied to the conductive plate in response to a control signal which selects one of the memory blocks, after the first and third voltages have been effectively transferred to the selected and unselected word lines.

## Brief Description of the Drawings

The advantages, characteristics and objects of the present invention may be more fully understood with reference to the following description of certain embodiments, given by way of examples only, in conjunction with the accompanying drawings, in which:

Figure 1A is an equivalent circuit of capacitance in the structure of a typical flash EEPROM cell;

Figure 1B is an equivalent circuit of capacitance in the structure of a plate-structured flash EEPROM cell;

Figure 2 is a perspective sectional schematic of a plate-structured flash EEPROM cell;

Figure 3 shows voltages used in a conventional programming operation;

Figure 4 is a circuit diagram of a NAND-type flash EEPROM according to a first embodiment of the invention;

Figure 5 is an equivalent circuit of capacitance in the structure of the flash EEPROM cell and transfer transistors of Figure 4;

Figure 6 shows a correlative characteristic of the voltages for a word line and a booster plate, for conventional flash memories, and flash memories of the present invention;

Figure 7 is a circuit diagram of a block decoder as shown in Figure 4;

Figure 8 is a circuit diagram of a section decoder as shown in Figure 4;

Figure 9 is a plate drive circuit according to the first embodiment;

Figure 10 shows voltages applied to a selected word line, unselected word lines and a plate for a programming operation, according to the first embodiment;

Figure 11 is a circuit diagram of a block decoder according to a second embodiment of the invention;

Figure 12 shows voltages applied to word lines, a booster plate and transfer transistors for a programming operation, according to the second embodiment;

Figure 13 is a circuit diagram of a NAND-type flash EEPROM according to a third embodiment of the invention;

Figures 14A and 14B show various circuits of a block decoder as shown in Figure 13; and

Figure 15 shows voltages applied to word lines, a booster plate and transfer transistors for a programming operation, according to the third embodiment.

In the figures, like reference numerals denote like or corresponding parts, and the prefix 'n' to a signal name means it activates at low level

## Detailed Description of the Drawings

## First Embodiment

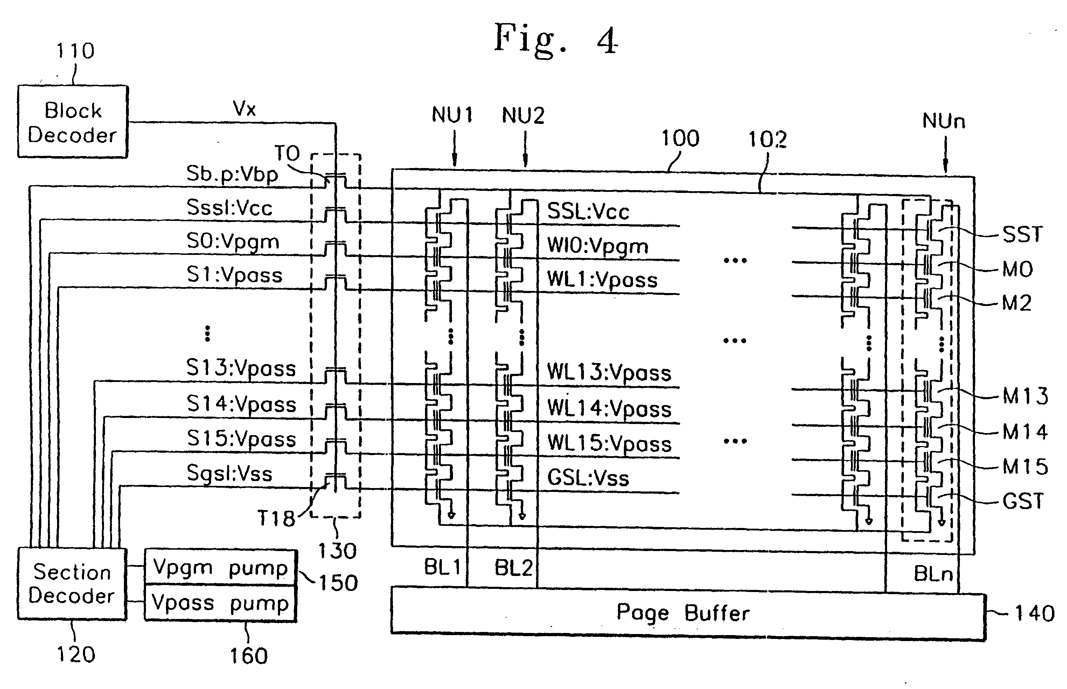

Figure 4 shows a circuit diagram of a NAND-type flash memory having booster plate 102, according to a first embodiment of the invention. Array block 100 consists of NAND cell units NU1 - NUn, covered by the booster plate. Each of the cell units NU1 - NUn has a string selection transistor SST connected to a bit line BL1 - BLn; a ground selection transistor GST connected to a ground, several floating gate memory cell transistors M0 - M15 connected between the string and ground selection transistors SST, GST, and booster plate 102 which extends over the cell units, covering the selection and cell transistors. Gates of each string and ground selection transistor are connected to string and ground selection lines, SSL and GSL, respectively. Groups of gates of corresponding cell transistors are connected to word lines WL0 - WL15. The structure of the cell transistor covered by booster plate 102 is as shown in Figure 2. Bit lines BL0 - BLn, are connected to a page buffer 140.

Booster plate 102, string selection transistor SST, cell transistors M0 - M15 and ground selection transistor GST are connected to outputs of a section decoder 120, through corresponding transfer transistors T0 - T18 of a switch circuit 130. Gates of transfer transistors T0 - T18 are commonly connected to a gate drive voltage Vx for transferring drive signals Sbp, Sssl, S0 - S15 and Sgsl, all generated from section decoder 120, to booster plate 102, string selection line SSL, word lines WL0 - WL15, and ground selection line GSL, respectively. Section decoder 120 receives Vpgm and Vpass each from Vpgm pump 150 and Vpass pump 160. Voltages Vcc and Vss are supply voltages. The voltages (Vbp, Vpgm, Vpass) labelled on the booster plate and signal lines in the figure will be explained below. The memory block and decoders of Figure 4 may correspond to a part of a whole memory array in the flash memory having a plurality of memory blocks.

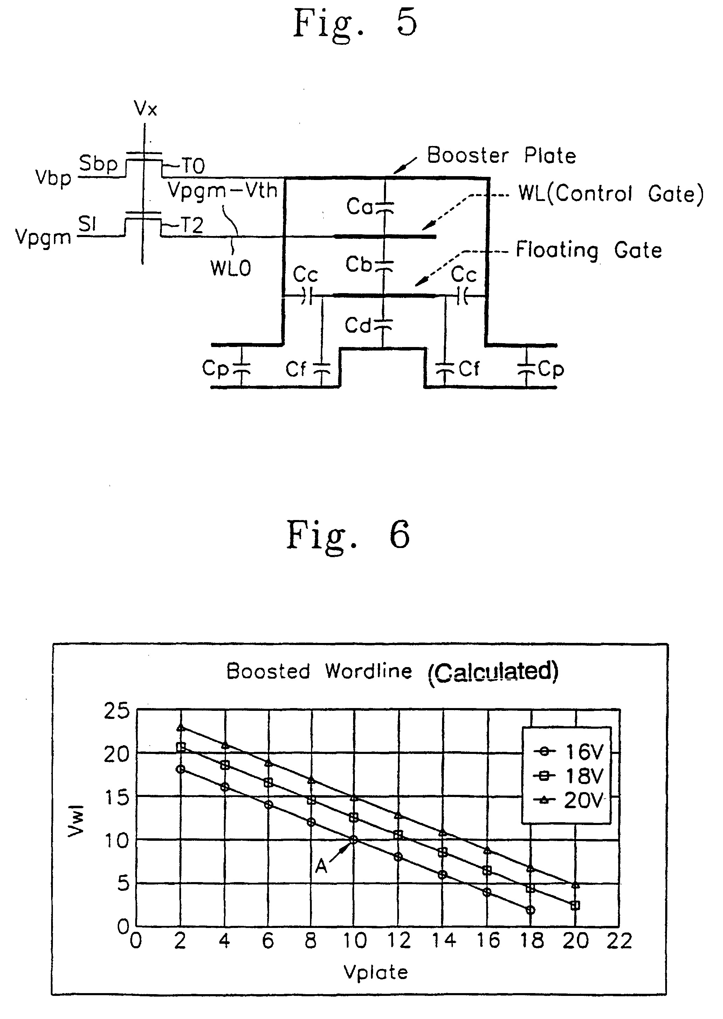

Figure 5 shows a capacitance equivalent of the structure of the flash EEPROM cell and transfer transistors of Figure 4, to explain a mechanism of boosting in a selected cell transistor by the capacitive coupling when programming voltage is applied. When drive voltage Vx from block decoder 110 is applied to gates of the transfer transistors, to apply booster plate voltage Vbp and program voltage Vpgm to booster plate 102 and word line WL0 (a selected word line) through T0 and T2, the selected word line WL0 charges up to Vpgm-Vth (referred to as Vwl; Vth is threshold voltage of the transfer transistor T2).

According to an aspect of the present invention, after a predetermined time, the booster plate is pulled up to Vbp to cause the voltage level of WL0 to be increased over Vwl(=Vpgm-Vth), by capacitor Ca between the booster plate and WL0, the control gate. The voltage of WL0 increases from Vwl, to Vwl* (>Vwl), which lowers the gate-to-source voltage Vgs of T2 which thereby becomes non-conductive. The voltage of WL0 is therefore higher than would have been possible with simple application of Vwl, without requiring a high voltage Vbp.

The voltage at the floating gate, Vfg, is the sum of a voltage Vfg1 coupled from Vw1*, and a voltage Vfg2 coupled from Vbp of the booster plate, as follows:

$$Vfg1 = \frac{Vw1^* \times Cb}{(Cb+2Cc+Cd+2Cf)} \, ,$$

$$Vfg2 = \frac{Vbp \times (C1 + 2Cc)}{(C1+2Cc+Cd+2Cf)} \tag{3}$$

where C1 = (Ca x Cb)/(Ca+Cb)

$$Vfg = Vfg1 + Vfg2 \tag{4}.$$

Then, while a programming operation is being carried out in the above manner, in which the booster plate receives a delayed voltage equal to that of the selected word line, an enhanced coupling ratio γc* of a selected cell transistor (or selected memory cell) may be summarised as:

$$\gamma c^*(plate) = \frac{Cb + C1 + 2Cc}{(Cb+2Cc+Cd+2Cf)} \tag{5}$$

The voltage applied to the booster plate may be other than equal to that of the selected word line.

Comparing the value of γc* of equation [5] with that of γc of equation [2],[(Cb+2Cc)/(Cb+2Cc+Cd+2Cf)], γc* is greater than yc by the value of C1/(Cb+2Cc+Cd+2Cf). In a typical case when values of the capacitance are applied into the equations of the coupling ratios, γc* is 1.08 while yc is 0.67. The enhanced coupling ratio makes it possible to accomplish a programming operation even with reduced voltage levels supplied to a selected word line and a booster plate.

Figure 6 shows different voltage levels for a selected word line and a booster plate for programming operations of the prior art, and of the present embodiment. The figure shows voltage values used in the prior art plotted onto axes of word line voltage (Vwl) and booster plate voltage (Vbp) used according to the present inmvention, for equivqlent progrqmming. Voltage levels applied to a selected word line and the booster plate are the same in the prior art. Assuming that this is also the case for the present invention, the prior art requires 16V to be applied to a selected word line and a booster plate, whereas the present invention requires only 10V for equivalent programming, as shown at point A. Scaling approximately with the graph of Figure 6, the voltage levels for the selected word line and booster plate according to the present invention may be lower than the conventional voltage levels by about 6V for equivalent programming.

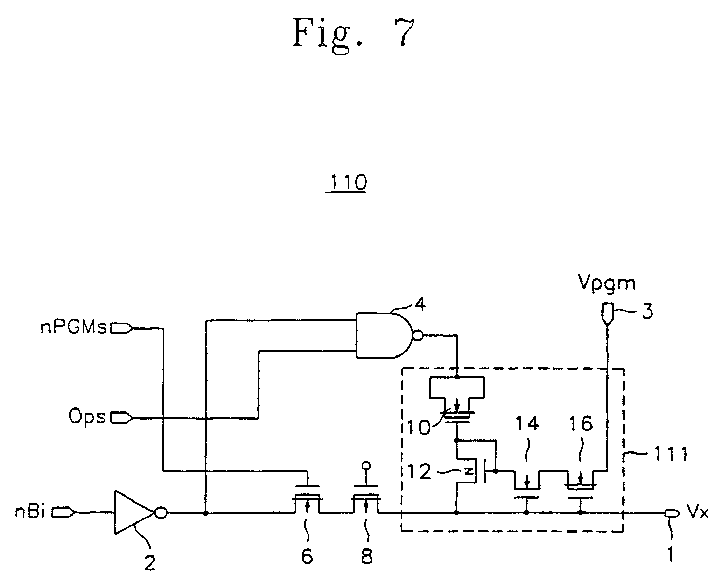

Figures 7 to 9, respectively show the circuit diagrams of block decoder 110, section decoder 120, and booster plate drive circuit, of Figure 4.

Referring to Figure 7, block selection signal nBi propagates through inverter 2 and is then applied to an input of NAND gate 4. An oscillating signal Ops is applied to a second input of NAND gate 4.

Block selection signal nBi is also connected through NMOS depletion transistors 6 and 8 to an output terminal 1, from which output voltage Vx is generated. Gates of transistors 6 and 8 are coupled to program signal nPGMs and a power supply voltage, respectively.

An output of NAND gate 4 is applied to an input of a switch pump 111, where it connects to an electrode of a depletion MOS capacitor 10. Another electrode of capacitor 10 is connected to Vx through diode-coupled NMOS transistor 12. A gate of NMOS transistor 12 is connected to program voltage Vpgm through NMOS transistor 14 and NMOS depletion transistor 16. Gates of transistors 14 and 16 are coupled to output terminal 1, and so receive voltage Vx.

When an oscillating output of NAND gate 4 is applied to capacitor 10 in response to Ops while nBi is low level (to select the corresponding memory block), a voltage at the gate and drain of transistor 12 is transferred to gates of transistors 14 and 16, which become conductive so as to connect Vpgm 3 to the gate and drain of transistor 12. Over several repetitions of such pumping steps, the voltage Vx at output terminal 1 reaches the level of Vpgm.

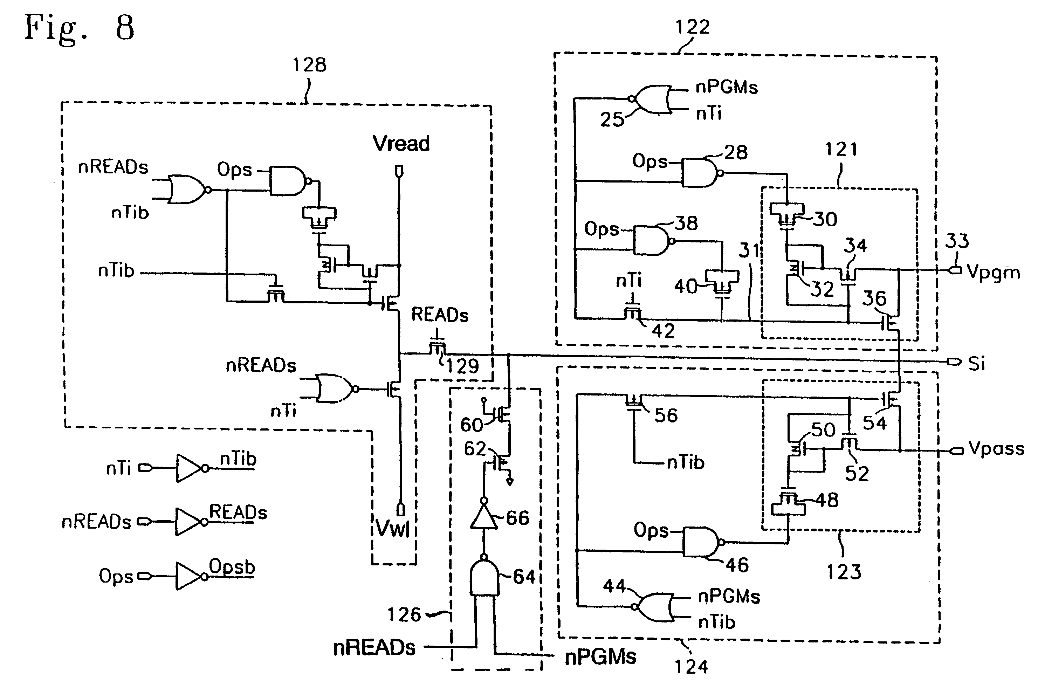

The circuit shown in Figure 8 corresponds to one unit in the section decoder 120 which is used to drive a word line signal Si for one word line. Other similar word line driver units of the section decoder are similarly constructed, together with this unit. The circuit shown is formed of three drive circuit portions 122, 124 and 128, and a discharging circuit 126. Drive circuits 122 and 124 are used for providing Vpgm and Vpass to Si, respectively, in a program operation. Drive circuit 128 is for a read operation, and does not affect programming operation. When not in a read operation, read signal READs is low level and turns off NMOS depletion transistor 129, disconnecting drive circuit 128 from Si.

In Figure 8, within drive circuit 122, switch pump 121 connects Vpgm to Si in response to an output of a NAND gate 28 receiving oscillating signal Ops together with a high output of NOR gate 25 receiving nPGMs and nTi. Signal nTi is generated from decoding address signals and activated at low level when a corresponding one of the word lines is selected during programming.

Switch pump 121 is formed of an NMOS transistor 36 connected between Vpgm and Si; a depletion MOS capacitor 30, one electrode of which is coupled to the output of NAND gate 28; a diode-coupled NMOS transistor 32, connected between the other electrode of capacitor 30 and the gate of transistor 36; and an NMOS transistor 34 connected between the gate of transistor 32 and Vpgm. The gate of transistor 34 is coupled to the gate of transistor 36, and to an output of a NAND gate 38 through a depletion MOS capacitor 40, and also to the output of NOR gate 25 through an NMOS depletion transistor 42 whose gate is coupled to nTi.

Drive circuit 122 is activated in a program operation when nPGMs is low level, setting the output of NOR gate 25 to high level. Voltage Vpgm is then supplied to the selected word line through the word line drive signal Si.

Drive circuit 124 supplies Vpass to a corresponding word line, through Si, during a program operation, when the corresponding word line is not selected.

In drive circuit 124, a switch pump 123 connects Vpass to Si in response to an output of a NAND gate 46. NAND gate 46 receives as inputs, the oscillating signal Ops and an output of a NOR gate 44. NOR gate 44 receives nPGMs and nTib (the complement of nTi) as inputs. Switch pump 123 is constructed of NMOS transistor 54 connected between Vpass and Si; depletion MOS capacitor 48 one electrode of which is coupled to the output of NAND gate 46; diode-coupled NMOS transistor 50 connected between the other electrode of capacitor 48 and gate of transistor 54; and NMOS transistor 52 connected between gate of transistor 50 and Vpass. The gate of transistor 52 is coupled to gate of transistor 54 and is also connected to the output of NOR gate 44 through NMOS depletion transistor 56 whose gate is coupled to nTib.

Drive circuits 122 and 124 alternately conduct, in accordance with whether or not the word line drive signal Si corresponds to a selected word line in a program mode. The selection of a word line to be programmed is represented by the logic level of signal nTi (or nTib) which activates one or other of the drive circuits 122, 124 while nPGMs is low, indicating programming mode. Signal nTi at low level indicates a selected word line, and activates drive circuit 122 to supply Vpgm to Si, while drive circuit 124 is shut off by nTib of high level. Alternatively, nTib at low level indicates an unselected word line, and activates drive circuit 124 to supply Vpass to Si, while drive circuit 122 is shut off by nTi at high level.

Discharging circuit 126 has NMOS depletion transistors 60 and 62 connected in series, between Si and a ground voltage. The gate of transistor 60 is coupled to a power source voltage. The gate of transistor 62 is coupled to an output of a NAND gate 64, through an inverter 66. NAND gate 64 receives signals nPGMs and nREADs as inputs. Transistor 62 connects Si to the ground potential to pull down the voltage level of the word line drive signal (or line) Si when the signals nPGMs and nREADs are both high, that is, when neither a program operation nor a read operation is enabled.

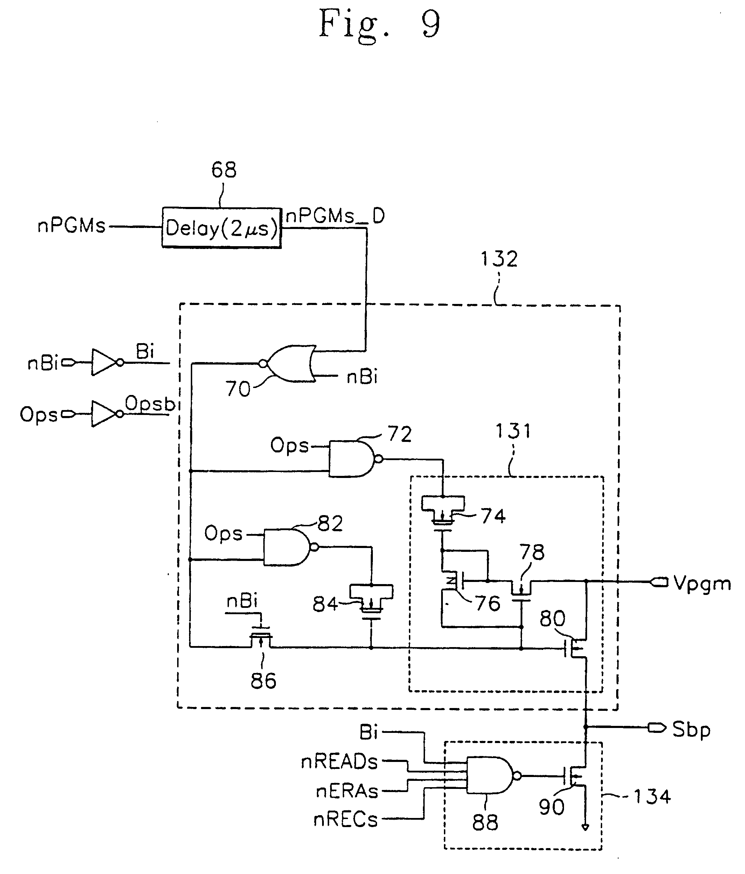

Figure 9 shows a booster plate drive circuit of the section decoder. The booster plate drive circuit includes a delay circuit 68; a voltage drive circuit 132; and a discharging circuit 134.

In voltage drive circuit 132, a switch pump 131 connects Vpgm to booster plate drive signal (or line) Sbp in response to an output of a NAND gate 72. NAND gate 72 receives the oscillating signal Ops, together with an output of a NOR gate 70, as inputs. NOR gate 70 itself receives delayed program signal nPGMs_D generated from delay circuit 68, and signal nBi, as inputs.

Switch pump 131 is formed of an NMOS transistor 80 connected between Vpgm and Sbp; a depletion MOS capacitor 74, one electrode of which is coupled to an output of a NAND gate 72; a diode-coupled NMOS transistor 76, connected between the other electrode of capacitor 74 and gate of transistor 80; and an NMOS transistor 78 connected between the gate of transistor 76 and Vpgm. The gate of transistor 78 is coupled to gate of transistor 76; also to an output of a NAND gate 82 through a depletion MOS capacitor 84; and also to the output of NOR gate 70 through NMOS depletion transistor 86, whose gate is coupled to nBi.

Signal nBi is generated from decoding address signals to select a memory block and is activated (low) when a corresponding one of memory blocks is selected.

Discharging circuit 134 utilises an NMOS transistor 90 connected between Sbp and a ground potential. The gate of transistor 90 responds to output of a NAND gate 88 which receives Bi (the complement of nBi), nREADs, nERAs and nRECs as inputs.

Voltage drive circuit 132 is activated by nPGMs_D at a predetermined time, e.g. 2ps, after nPGMs becomes low level. The output of NOR gate 70 is thereby set into high level, so that Vpgm is supplied to a selected booster plate through Sbp. Transistor 90 of the discharging circuit 134 turns on when at least one of the input signals of NAND gate 88 becomes low level, i.e. selected booster plate is discharged when the corresponding memory block is not selected, or when a current operation is not the programming step.

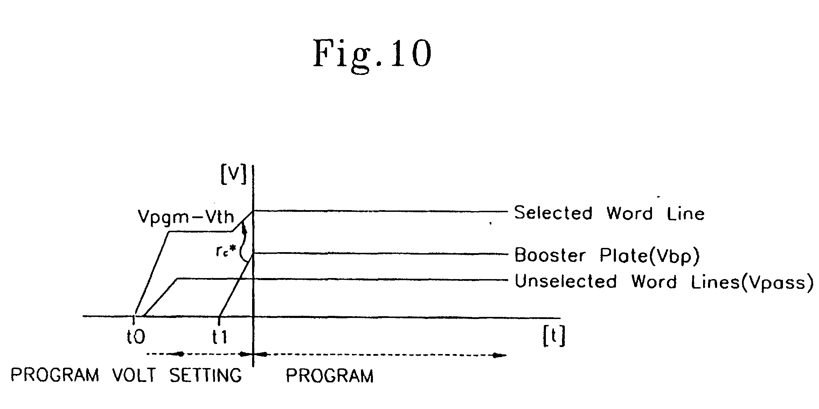

An explanation of the programming operation with the booster plate follows, with reference to the voltages of the drive signals generated by the block decoder and section decoder, referring to Figures 4 and 10. It is assumed that the word line WL0 is selected.

As shown in figure 10, in the program voltage set-up period from t0, Vpgm for the selected word line WL0 is supplied from section decoder 120 through the corresponding drive signal S0. Vpass is applied to the unselected word lines WL1 - WL15 through their drive signals S1 - S15. Drive signals Sssl and Sgsl for the string and ground selection lines have the levels of Vcc and Vss, respectively. Vpgm passes through the corresponding transfer transistor T2 and is reduced to Vpgm-Vth, which is applied to selected word line WL0 until time t1.

Time t1 occurs 2μs after time t0, established by the delay circuit 68 of the booster plate drive circuit. Voltage Vbp starts to increase and by capacitive coupling with the ratio γc* of equation [5], results in boosting the voltage level of the selected word line above Vpgm-Vth. Next, the operation enters the program period. The self-boosted word line voltage (higher than Vpgm-Vth) aids programming a selected cell transistor M0, while the unselected word lines are still held at Vpass. The selected word line WL0 is at the self-boosted voltage, raising the floating gate voltage Vfg shown in equation [4]. Accordingly, electrons are moved to the floating gate by Fowler-Nordheim tunnelling, thereby raising the threshold voltage of the selected memory cell, placing it in a programmed state.

## Second Embodiment

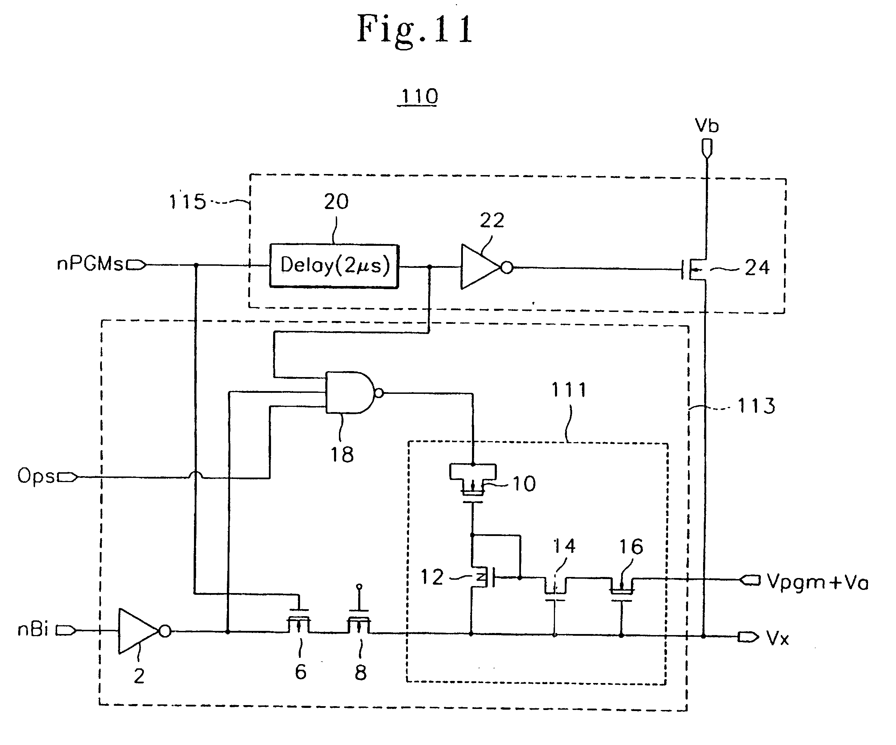

Figure 11 shows an alternative circuit of the block decoder 110 for controlling the transfer transistors T0 - T18, as shown in Figure 4. This alternative circuit represents a second embodiment of the invention. Similar elements in Figure 11 have similar reference numerals as those of Figure 7.

The block decoder of Figure 11 is formed of two drive circuits 113 and 115, in order to accomplish efficient control of the transfer transistors.

Drive circuit 113 includes a switch pump 111, in which the gate of an NMOS transistor 12 is connected to one electrode of capacitor 10 and also to a source of a voltage (Vpgm+Va) (a voltage higher than Vpgm) through channels of NMOS transistor 14 and NMOS depletion transistor 16.

Capacitor 10 of switch pump 111 is coupled to an output of NAND gate 18 which receives as inputs, the oscillating signal Ops; Bi, the inverted signal of nBi; and nPGM_D, the delayed nPGMs (for instance, delayed by about 2ps by delay circuit 20).

Signal Bi is coupled to Vx through NMOS depletion transistors 6 and 8 whose gates are respectively coupled to nPGMs and a supply voltage such as Vcc.

The gates of the transistors 14 and 16 are also coupled to Vx.

Drive circuit 115 has a delay circuit 20 delaying nPGMs by about 2μs to produce nPGMs_D. It also has an inverter 22 to invert nPGMs_D; and an NMOS transistor 24 connected between voltage source of Vb and Vx, the gate of which receives the inverted nPGMs_D.

The voltage Vb is selected to be between a voltage applied to the booster plate and a voltage applied to the selected word line.

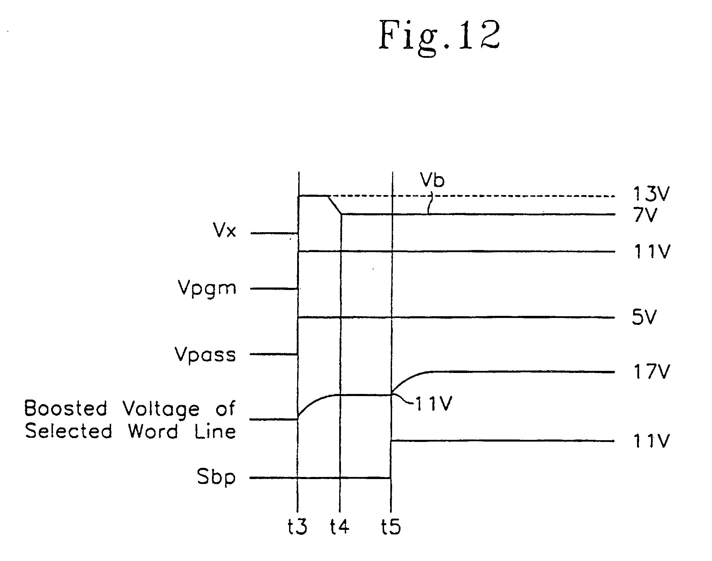

Figure 12 shows a timing diagram of programming signals used with the block decoder Figure 11.

At time t3, the block decoder generates Vx, such as 13V, i.e. Vpgm+Va, as an initial voltage level. Voltage Vpgm is generated, such as 11V, to a corresponding drive line of a selected word line. Voltage Vpass, such as 5V, is applied to unselected word lines.

The Vpgm+Va of 13V secures a full transfer of Vpgm to the selected word line. Then, the selected word line is charged up to 11V of Vpgm through a corresponding transfer transistor (e.g. T2 for MO).

After the delay from delay circuit 20, at time t4, the voltage Vx goes to the level of Vb, e.g. 7V.

The output of delay circuit 20, nPGMs_D of low level causes the output of NAND gate 18 to be high, that sets switch pump 111 into a null state, allowing voltage Vx to drop. Meanwhile, transistor 24 is switched on, so as to transfer Vb (7V) to Vx. This transition of Vx from 13V to 7V makes the corresponding transfer transistor (T2) turn off, so the selected word line enters a floating state.

Moreover, after transferring Vpgm to the selected word line, there is no need to maintain the 13V Vpgm+Va because Vpgm has already been effectively transferred to the selected word line during the delay time - such as about 2μs. This time delay may be adjusted as required, to at least secure a stable application of Vpgm to the selected word line.

Thereafter, at time t5, the booster plate voltage, such as 11V, Sbp is applied to the booster plate 102 from the booster plate drive circuit in the section decoder 120 shown in Figure 4. The voltage level of the selected word line is charged up to about 17V by the capacitive coupling between the booster plate and control gate coupled to the selected word line.

Also in this case, the voltage Vfg induced on the floating gate fg accords with the equation [4].

### Third Embodiment

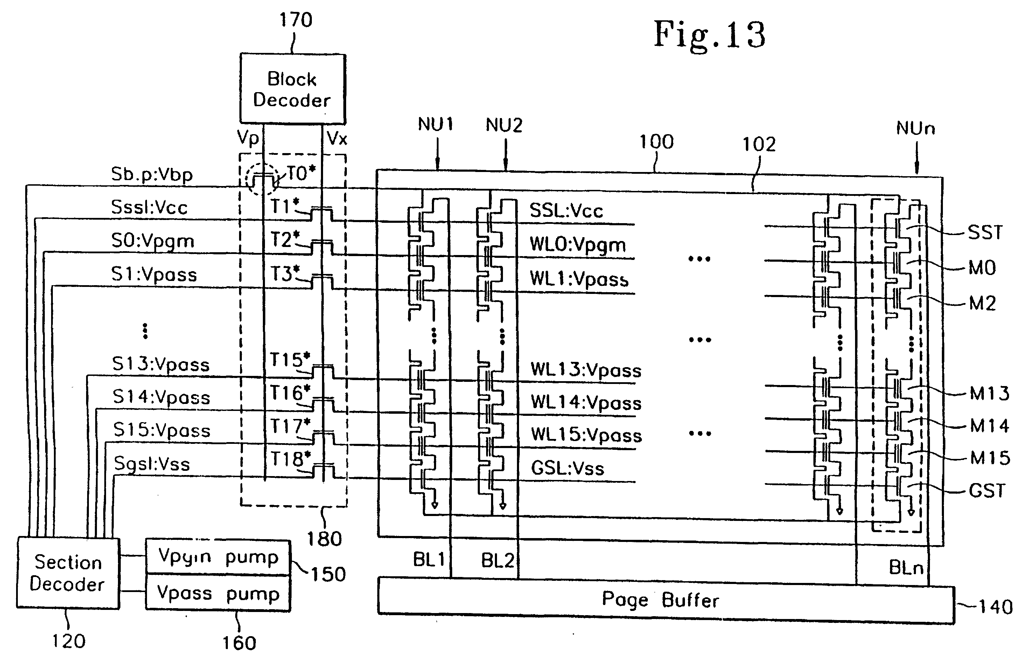

Figure 13 shows a construction of a NAND-type flash EEPROM according to a third embodiment of the present invention.

In this third embodiment, block decoder 170 generates both Vx and Vp voltages. Voltage Vp is applied only to gate of transfer transistor T0* of switching circuit 180. That transistor T0* is connected between the booster plate drive line Sbp and booster plate 102, while Vx is applied to other transfer transistors T1 - T18. Each of these other transfer transistors is respectively connected between corresponding drive lines Sssl - Sgsl, and selection lines SSL - GSL, including the word lines WL0 - WL15.

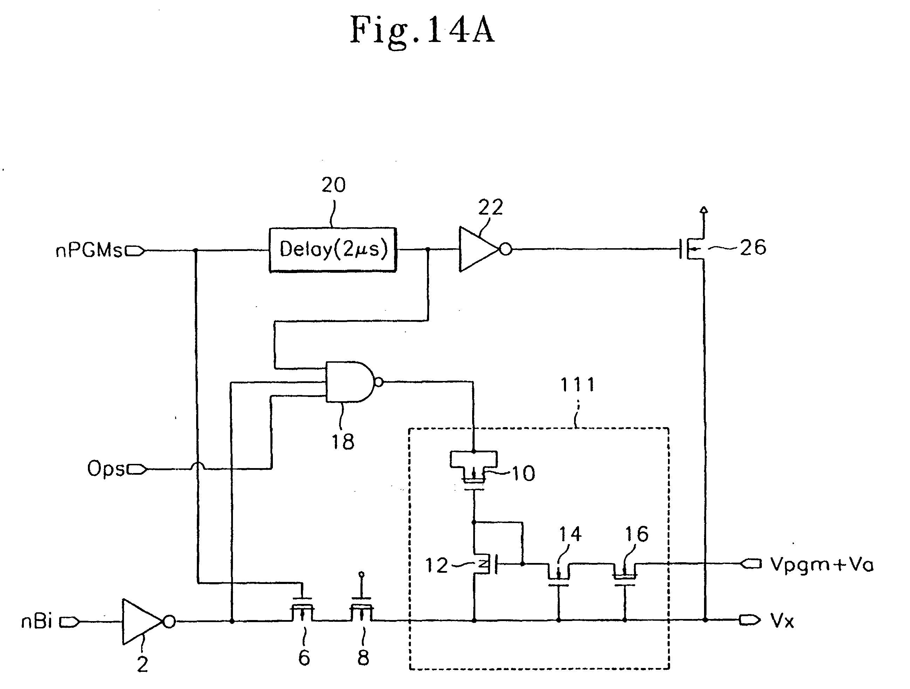

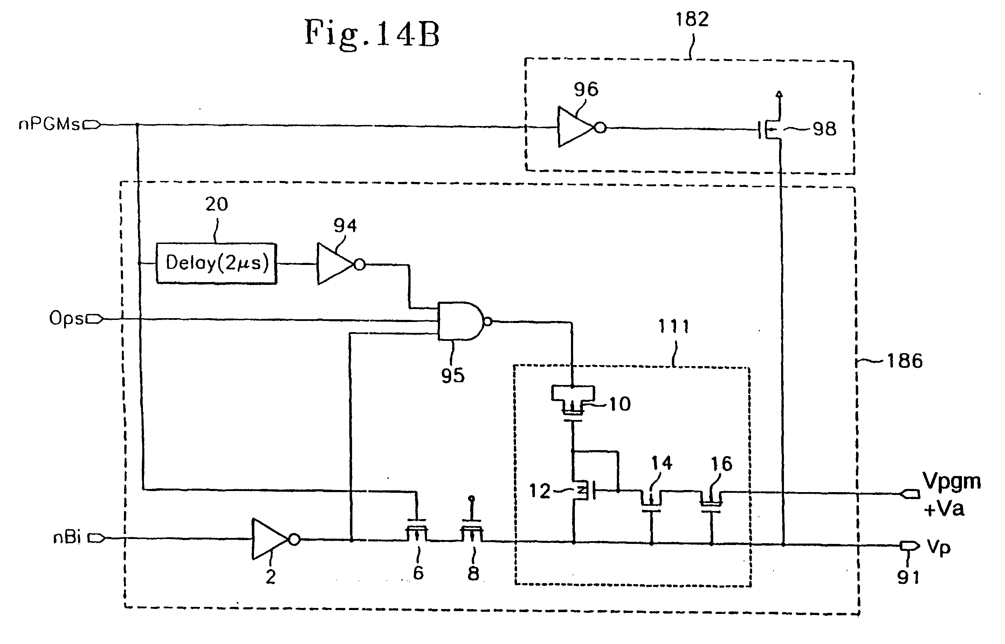

A transfer transistor T0* may be provided for each block. Block decoder 170 has two kinds of voltage drive circuits, for Vp and Vx respectively, as disclosed below with reference to Figures 14A and 14B. The other features of the circuit of Figure 13 correspond with those of Figure 4.

Figure 14A shows a drive circuit generating Vx to be applied to the gates of transfer transistors T1 - T18, similar to that shown in Figure 11. However, the transistor 26 is connected between the ground potential and Vx, unlike the transistor 24 of figure 11, which was coupled between Vb and Vx.

Figure 14B shows a circuit for generating Vp, which is applied to the gate of transfer transistor T0*. The circuit has two drive circuit parts 182 and 186.

Drive circuit 182 includes an inverter 96 receiving the signal nPGMs; and also includes an NMOS transistor 98 connecting Vp to ground in response to the output of inverter 96.

In drive circuit 186, the signal nPGMs, delayed by delay circuit 20 and inverted by inverter 94, is applied to an input of a NAND gate 95. NAND gate 95 also receives Ops and Bi, the inverted signal of nBi, as inputs. An output of NAND gate 95 is applied to capacitor 10 of switch pump 111, which has the same construction as the switch pump of Figure 11.

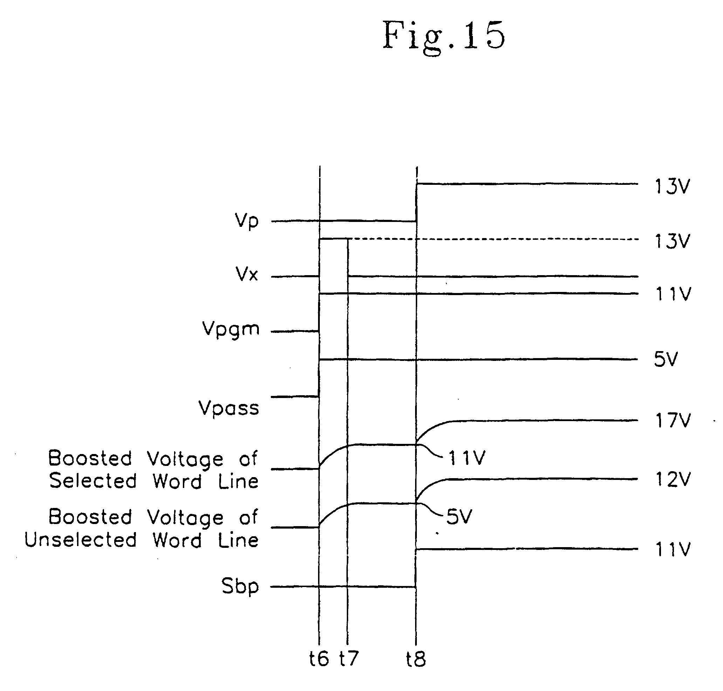

A programming operation according to the third embodiment is described below, with reference to the timing chart of Figure 15.

When programming mode is initiated, the signal nPGMs goes low and causes a voltage Vpgm of 11V and a voltage Vpass of 5V to be respectively generated from the charge pumps 150 and 160.

Concurrently, in the circuit of Figure 14A, the NAND gate 18 receives the delayed nPGMs (nPGMs_D) and Bi at high levels while Ops is oscillating high and low. This causes the output of NAND gate 18 to oscillate and activate the switch pump 111.

At time t6, Vx goes to the Vpgm+Va value of about 13V that is applied to the gates of transfer transistors T1 - T18. The transfer transistors T1 - T18 connect respective drive lines Sssl - Sgsl to respective selection lines SSL - GSL, as shown in Figure 13. During this time, Vp is held at the ground potential, because the low nPGMs turns transistor 98 on through inverter 96 (figure 14B).

At time t7, the delay time of about 2µs after t6, the delayed nPGMs causes transistor 26 of Figure 14A to connect the current Vx to the ground potential. This disables the switch pump 111 of Figure 14A. Voltage Vx falls to the ground potential and turns the transfer transistor off. This causes all of the word lines to be in a floating state.

Thereafter, at time t8, if the booster plate voltage (Sbp) of 11V is applied to the booster plate 102 from the booster plate drive circuit in the section decoder 120 shown in Figure 4, the voltage of the selected word line is pulled up to about 17V by the capacitive coupling between the booster plate and the selected word line. The unselected word lines are also affected by the capacitive coupling and are thereby boosted above Vpass, to about 12V. This may allow reduction in the level of Vpass applied.

As described above, the voltage applied to the booster plate is activated at a predetermined time after the programming voltage has been applied to a selected word line. A resulting voltage of the selected word line increases higher than the voltage forcibly supplied. This advantageously provides self-boosting by a capacitive coupling mechanism.

It is possible to accomplish a reliable programming operation even with a lower booster plate voltage and word line voltage, which reduces stress on memory cells otherwise encountered due to an excessively high voltage lasting for a long time in the programming operation.

The timely sequential application of the programme voltage and booster plate voltage enhances the value of the coupling ratio of the floating gate. This serves to amplify the effective electric field, aiding the programming operation. This timing and application of voltages allows a reduction in the time needed for charging or discharging of the booster plate, which has a much greater capacitance than any other conductive lines in the memory. This reduces the overall current consumption during the programming operation.

Moreover, as seen in the third embodiment, the unselected word lines are held at Vpass, and can be put into a self-boosting field when the booster plate voltage is applied thereto. A reduced Vpass voltage may be enough to set the unselected word lines and memory cells into stable pass states for the selected word line and memory cell, which also contributes to a decrease of an overall power consumption.

## Claims

1. A flash memory comprising:

   - an array of memory cells (100) having sources, drains, floating gates and control gates, the array including a conductive plate (102) formed over the memory cells to provide a capacitive coupling (Ca, Cc) between the memory cells and the conductive plate;

   - a first voltage source (150) to supply a first voltage (Vpgm) to the control gate (WL) of a selected one of the memory cells;

      **characterised in that** the flash memory further comprises:

   - means (24; 26, 98) for placing the control gates in a floating state after (t4, t7) the control gate (WL) of the selected one of the memory cells has been charged up to a predetermined potential by the first voltage source (150); and

   - a second voltage source (132) to supply a second voltage (Vbp) to the conductive plate after (t5, t8) the control gates have been placed in a floating state.

2. A flash memory according to claim 1, further comprising:

   - a switching circuit (130) to transfer the first voltage to said control gate (WL) of the selected one of the memory cells and the second voltage to the conductive plate, in response to a control signal.

3. A flash memory according to claim 1 or claim 2, further comprising:

   - a third voltage source to supply a third voltage (Vpass) to the control gates of unselected memory cells of the memory cells; and

- a switching circuit to transfer the third voltage to the control gates of the unselected memory cells of the memory cells, in response to control signals, the switching circuit making the control gates be in a floating state after all of the control gates of the memory cells have been charged up to predetermined potentials and before the second voltage is applied to the conductive plate.

4. A flash memory according to any preceding claim wherein the array is divided into a plurality of memory blocks, and wherein the second voltage source supplies the second voltage to the conductive plate, in response to a control signal which selects one of the memory blocks.

5. A flash memory according to claim 4 when dependent on claims 2 or 3 wherein the control signals include:

   - a first drive control signal which makes all of the control gates be in a floating state after all of the control gates have been charged up to predetermined potentials and before the second voltage is applied to the conductive plate, and

   - a second drive control signal which connects the second voltage to the conductive plate after said all of the control gates of the memory cells have been charged up to the predetermined potentials.

6. A flash memory according to claim 1, further comprising:

   the array being divided into a plurality of memory blocks, the control gates of the memory cells being coupled to word lines;

   - a plurality of drive lines (S0 - S15) connected to the control gates (WL0 - WL15) through corresponding transfer transistors (T2 - T17; T2* - T17*);

   - a block decoder (170) to control the transfer transistors; and

   - a section decoder (120) coupled to the drive lines; the section decoder supplying the first voltage (Vpgm), the second voltage (Vbp), and further supplying a third voltage (Vpass) to unselected word lines;

   wherein the second voltage is applied to the conductive plate after the first voltage has been effectively transferred to the selected one of the memory cells through the associated word line.

7. A flash memory according to claim 6, further comprising:

   - further drive line (Sb.p) corresponding to the conductive plate;

   - a switching circuit including a transfer transistor (T0, T0*) interposed between a drive line and the conductive plate and a plurality of transfer transistors (T1 - T18; T1* - T18*) interposed between corresponding drive lines and word lines,

   - the block decoder (170) being coupled to gates of the transfer transistors of the switching circuit, a first output of the block decoder (Vp) being coupled to the gate of the transfer transistor connected to the conductive plate and a second output of the block decoder (Vx) being coupled to the gates of the transfer transistors connected to the word lines;

   wherein the second voltage (Vbp) is applied to the conductive plate, in response to a control signal which selects one of the memory blocks, after the first and third voltages have been effectively transferred to the selected and unselected word lines.

8. A method for operating a flash memory comprising an array of memory cells (100) having sources, drains, floating gates and control gates, the array including a conductive plate (102) formed over the memory cells to provide a capacitive coupling (Ca, Cc) between the memory cells and the conductive plate, and a first voltage source (150); wherein

   - the first voltage source (150) supplies a first voltage (Vpgm) to the control gate (WL) of a selected one of the memory cells;

**characterised in that**:

- the control gates are placed in a floating state after (t4, t7) the control gate (WL) of the selected one of the memory cells has been charged up to a predetermined potential by the first voltage source (150); and

- a second voltage source (132) provided in the flash memory supplies a second voltage (Vbp) to the conductive plate after (t5, t8) the control gates have been placed in a floating state.

9. A method according to claim 8, further comprising:

   transferring the first voltage to a control gate (WL) of the selected one of the memory cells, and
   transferring the second voltage (Vbp) to the conductive plate, in response to a control signal.

10. A method according to claim 8 or claim 9, further comprising:

    supplying a third voltage (Vpass); and
    transferring the third voltage to the control gates of the unselected memory cells of the memory cells, in response to control signals,
    the control gates (WL) being in a floating state after all of the control gates of the memory cells have been charged up to predetermined potentials and before the second voltage is applied to the conductive plate.

11. A method according to any of claims 9 or 10 wherein the array is divided into a plurality of memory blocks, and the second voltage is supplied to the conductive plate in response to a control signal which selects one of the memory blocks.

12. A method according to claim 11 when dependent on claim 10 wherein:

    the control signals include:

    - a first drive control signal which makes all of the control gates be in a floating state after all of the control gates have been charged up to predetermined potentials and before the second voltage is applied to the conductive plate, and

    - a second drive control signal which connects the second voltage to the conductive plate after said all of the control gates of the memory cells have been charged up to the predetermined potentials.

13. A method according to claim 8, further comprising:

    dividing the array into a plurality of memory blocks, coupling the control gates of the memory cells to word lines;
    connecting a plurality of drive lines to the control gates through
    corresponding transfer transistors and word lines;
    controlling the transfer transistors with a block decoder; and
    coupling a section decoder (120) to the drive lines;
    the section decoder supplying the first voltage, the second voltage, and further supplying a third voltage (Vpass) to unselected word lines;

    wherein the second voltage is applied to the conductive plate after the first voltage has been effectively transferred to the selected one of the word lines.

14. A method according to claim 13, further comprising:

    coupling a further drive line (Sb.p) to the conductive plate (102);
    providing a switching circuit including a transfer transistor (T0; T0*) interposed between a corresponding one of the drive lines and the conductive plate and a plurality of transfer transistors (T1 - T18; T1* - T18*) interposed between corresponding drive lines and word lines;
    coupling the block decoder to gates of the transfer transistors of the switching circuit, a first output (Vp) of the block decoder being coupled to the gate of the transfer transistor connected to the conductive plate and a second output (Vx) of the block decoder being coupled to the gates of the transfer transistors connected to the word lines,
applying the second voltage to the conductive plate in response to a control signal which selects one of the memory blocks, after the first and third voltages have been effectively transferred to the selected and unselected word lines.

**Patentansprüche**

1.  Flash-Speicher mit:

    -   einem Feld von Speicherzellen (100) mit Source-, Drain-, floatenden Gate- und Steuergate-Elektroden, wobei das Feld eine leitfähige Platte (102) beinhaltet, die über den Speicherzellen ausgebildet ist, um eine kapazitive Kopplung (Ca, Cc) zwischen den Speicherzellen und der leitfähigen Platte bereitzustellen;

    -   einer ersten Spannungsquelle (150), um der Steuergate-Elektrode (WL) einer ausgewählten der Speicherzellen eine erste Spannung (Vpgm) zuzuführen;

    **dadurch gekennzeichnet, dass** der Flash-Speicher des Weiteren beinhaltet:

    -   Mittel (24; 26, 98), um die Steuergate-Elektroden in einen floatenden Zustand zu versetzen, nachdem (t4, t7) die Steuergate-Elektrode (WL) der ausgewählten der Speicherzellen durch die erste Spannungsquelle (150) auf ein vorgegebenes Potential aufgeladen wurde; und

    -   eine zweite Spannungsquelle (132), um der leitfähigen Platte eine zweite Spannung (Vbp) zuzuführen, nachdem (t5, t8) die Steuergate-Elektroden in einen floatenden Zustand versetzt wurden.

2.  Flash-Speicher nach Anspruch 1, der des Weiteren beinhaltet:

    -   einen Umschaltschaltkreis (130), um die erste Spannung zu der Steuergate-Elektrode (WL) der ausgewählten der Speicherzellen und die zweite Spannung zu der leitfähigen Platte in Reaktion auf ein Steuersignal zu übertragen.

3.  Flash-Speicher nach Anspruch 1 oder Anspruch 2, der des Weiteren beinhaltet:

    -   eine dritte Spannungsquelle, um den Steuergate-Elektroden der nicht ausgewählten Speicherzellen der Speicherzellen eine dritte Spannung (Vpass) zuzuführen; und

    -   einen Umschaltschaltkreis, um die dritte Spannung zu den Steuergate-Elektroden der nicht ausgewählten Speicherzellen der Speicherzellen in Reaktion auf Steuersignale zu übertragen, wobei der Umschaltschaltkreis die Steuergate-Elektroden in einen floatenden Zustand versetzt, nachdem alle Steuergate-Elektroden der Speicherzellen auf vorgegebene Potentiale aufgeladen wurden und bevor die zweite Spannung an die leitfähige Platte angelegt wird.

4.  Flash-Speicher nach irgendeinem vorhergehenden Anspruch, wobei das Feld in eine Mehrzahl von Speicherblöcken unterteilt ist und wobei die zweite Spannungsquelle der leitfähigen Platte die zweite Spannung in Reaktion auf ein Steuersignal zuführt, das einen der Speicherblöcke auswählt.

5.  Flash-Speicher nach Anspruch 4 in Verbindung mit Anspruch 2 oder 3, wobei die Steuersignale umfassen:

    -   ein erstes Treibersteuersignal, das alle Steuergate-Elektroden in einen floatenden Zustand versetzt, nachdem alle Steuergate-Elektroden auf vorgegebene Potentiale aufgeladen wurden und bevor die zweite Spannung an die leitfähige Platte angelegt wird, und

    -   ein zweites Treibersteuersignal, das die zweite Spannung mit der leitfähigen Platte verbindet, nachdem alle Steuergate-Elektroden der Speicherzellen auf die vorgegebenen Potentiale aufgeladen wurden.

6.  Flash-Speicher nach Anspruch 1, der des Weiteren beinhaltet:

- eine Aufteilung des Feldes in eine Mehrzahl von Speicherblöcken, wobei die Steuergate-Elektroden der Speicherzellen an Wortleitungen gekoppelt sind;

- eine Mehrzahl von Treiberleitungen (S0 bis S15), die mit den Steuergate-Elektroden (WL0 bis WL15) über entsprechende Transfer-Transistoren (T2 bis T17; T2* bis T17*) verbunden sind;

- einen Block-Dekoder (170), um die Transfer-Transistoren zu steuern; und

- einen Abschnitts-Dekoder (120), der mit den Treiberleitungen gekoppelt ist; wobei der Abschnitts-Dekoder die erste Spannung (Vpgm), die zweite Spannung (Vpb) und des Weiteren eine dritte Spannung (Vpass) für nicht ausgewählte Wortleitungen liefert;

wobei die zweite Spannung an die leitfähige Platte angelegt wird, nachdem die erste Spannung durch die zugehörige Wortleitung effektiv zu der ausgewählten der Speicherzellen übertragen wurde.

7. Flash-Speicher nach Anspruch 6, der des Weiteren beinhaltet:

- eine weitere, zu der leitfähigen Platte gehörige Treiberleitung (Sb. p);

- einen Umschaltschaltkreis, der einen Transfer-Transistor (T0, T0*), der zwischen eine Treiberleitung und die leitfähige Platte eingefügt ist, und eine Mehrzahl von Transfer-Transistoren (T1 bis T18; T1* bis T18*) beinhaltet, die zwischen entsprechende Treiberleitungen und Wortleitungen eingefügt sind,

- wobei der Block-Dekoder (170) mit Gate-Elektroden der Transfer-Transistoren des Umschaltschaltkreises gekoppelt ist, ein erster Ausgang des Block-Dekoders (Vp) mit dem Gate des Transfer-Transistors gekoppelt ist, der mit der leitfähigen Platte verbunden ist, und ein zweiter Ausgang des Block-Dekoders (Vs) mit den Gate-Elektroden der Transfer-Transistoren gekoppelt ist, die mit den Wortleitungen verbunden sind;

wobei die zweite Spannung (Vbp) an die leitfähige Platte in Reaktion auf ein Steuersignal angelegt wird, das einen der Speicherblöcke auswählt, nachdem die erste und die dritte Spannung effektiv zur ausgewählten und zu den nicht ausgewählten Wortleitungen übertragen wurden.

8. Verfahren zum Betrieb eines Flash-Speichers mit einem Feld von Speicherzellen (100) mit Source-, Drain-, floatenden Gate- und Steuergate-Elektroden, wobei das Feld eine leitfähige Platte (102) beinhaltet, die über den Speicherzellen ausgebildet ist, um eine kapazitive Kopplung (Ca, Cc) zwischen den Speicherzellen und der leitfähigen Platte bereitzustellen, und einer ersten Spannungsquelle (150); wobei

- die erste Spannungsquelle (150) der Steuergate-Elektrode (WL) einer ausgewählten der Speicherzellen eine erste Spannung (Vpgm) zuführt;

**dadurch gekennzeichnet, dass**

- die Steuergate-Elektroden in einen floatenden Zustand versetzt werden, nachdem (t4, t7) die Steuergate-Elektrode (WL) der ausgewählten der Speicherzellen durch die erste Spannungsquelle (150) auf ein vorgegebenes Potential aufgeladen wurde; und

- eine zweite Spannungsquelle (132), die in dem Flash-Speicher vorgesehen ist, der leitfähigen Platte eine zweite Spannung (Vbp) zuführt, nachdem (t5, t8) die Steuergate-Elektroden in einen floatenden Zustand versetzt wurden.

9. Verfahren nach Anspruch 8, das des Weiteren umfasst:

Übertragen der ersten Spannung zu einer Steuergate-Elektrode (WL) der ausgewählten der Speicherzellen und

Übertragen der zweiten Spannung (Vbp) zu der leitfähigen Platte in Reaktion auf ein Steuersignal.

10. Verfahren nach Anspruch 8 oder Anspruch 9, das des Weiteren umfasst:

Zuführen einer dritten Spannung (Vpass); und
Übertragen der dritten Spannung zu den Steuergate-Elektroden der nicht ausgewählten Speicherzellen der Speicherzellen in Reaktion auf Steuersignale,

wobei sich die Steuergate-Elektroden (WL) in einem floatenden Zustand befinden, nachdem alle Steuergate-Elektroden der Speicherzellen auf vorgegebene Potentiale aufgeladen wurden und bevor die zweite Spannung an die leitfähige Platte angelegt wird.

11. Verfahren nach irgendeinem der Ansprüche 9 oder 10, wobei das Feld in eine Mehrzahl von Speicherblocken unterteilt wird und die zweite Spannung in Reaktion auf ein Steuersignal, das einen der Speicherblöcke auswählt, der leitfähigen Platte zugeführt wird.

12. Verfahren nach Anspruch 11 in Verbindung mit Anspruch 10, wobei
die Steuersignale umfassen:

- ein erstes Treibersteuersignal, das alle Steuergate-Elektroden in einen floatenden Zustand versetzt, nachdem alle Steuergate-Elektroden auf vorgegebene Potentiale aufgeladen wurden und bevor die zweite Spannung an die leitfähige Platte angelegt wird, und

- ein zweites Treibersteuersignal, das die zweite Spannung mit der leitfähigen Platte verbindet, nachdem alle Steuergate-Elektroden der Speicherzellen auf die vorgegebenen Potentiale aufgeladen wurden.

13. Verfahren nach Anspruch 8, das des Weiteren umfasst:

Unterteilen des Feldes in eine Mehrzahl von Speicherblöcken, wobei die Steuergate-Elektroden der Speicherzellen mit Wortleitungen gekoppelt werden;

Verbinden einer Mehrzahl von Treiberleitungen mit den Steuergate-Elektroden mittels zugehöriger Transfer-Transistoren und Wortleitungen;

Steuern der Transfer-Transistoren mit einem Block-Dekoder; und

Koppeln eines Abschnitts-Dekoders (120) mit den Treiberleitungen;

wobei der Abschnitts-Dekoder die erste Spannung, die zweite Spannung und des Weiteren eine dritte Spannung (Vpass) den nicht ausgewählten Wortleitungen zuführt;
wobei die zweite Spannung der leitfähigen Platte zugeführt wird, nachdem die erste Spannung effektiv zu der ausgewählten Wortleitung übertragen wurde.

14. Verfahren nach Anspruch 13, das des Weiteren umfasst:

Koppeln einer weiteren Treiberleitung (Sb.p) mit der leitfähigen Platte (102);

Bereitstellen eines Umschaltschaltkreises, der einen Transfer-Transistor (T0; T0*), der zwischen eine entsprechende Treiberleitung und die leitfähige Platte eingefügt ist, und eine Mehrzahl von Transfer-Transistoren (T1 bis T18; T1* bis T18*) beinhaltet, die zwischen entsprechende Treiberleitungen und Wortleitungen eingefügt sind;

Koppeln des Block-Dekoders mit den Gate-Elektroden der Transfer-Transistoren des Umschaltschaltkreises, wobei ein erster Ausgang (Vp) des Block-Dekoders mit der Gate-Elektrode des Transfer-Transistors gekoppelt wird, der mit der leitfähigen Platte verbunden ist, und ein zweiter Ausgang (Vx) des Block-Dekoders mit den Gate-Elektroden der Transfer-Transistoren gekoppelt wird, die mit den Wortleitungen verbunden sind,

Anlegen der zweiten Spannung an die leitfähige Platte in Reaktion auf ein Steuersignal, das einen der Speicherblöcke auswählt, nachdem die erste und die dritte Spannung effektiv auf die ausgewählte und die nicht ausgewählten Wortleitungen übertragen wurden.

**Revendications**

1. Mémoire flash comprenant :

   - un réseau de cellules de mémoire (100) ayant des sources, des drains, des grilles flottantes et des grilles de commande, le réseau incluant une plaque conductrice (102) formée sur les cellules de mémoire pour procurer un couplage capacitif (Ca, Cc) entre les cellules de mémoire et la plaque conductrice;
   - une première source de tension (150) pour appliquer une première tension (Vpgm) à la grille de commande (WL) de l'une sélectionnée des cellules de mémoire;

   **caractérisée en ce que** la mémoire flash comprend en outre:

   - un moyen (24; 26, 98) pour placer les grilles de commande dans un état flottant après (t4, t7) que la grille de commande (WL) de la cellule sélectionnée parmi les cellules de mémoire a été chargée jusqu'à un potentiel prédéterminé par la première source de tension (150); et
   - une seconde source de tension (132) pour appliquer une seconde tension (Vbp) à la plaque conductrice après (t5, t8) que les grilles de commande ont été placées dans un état flottant.

2. Mémoire flash selon la revendication 1, comprenant en outre :

   - un circuit de commutation (130) pour transférer la première tension à la grille de commande (WL) de la cellule sélectionnée parmi les cellules de mémoire et la seconde tension à la plaque conductrice, en réponse à un signal de commande.

3. Mémoire flash selon la revendication 1 ou la revendication 2, comprenant en outre :

   - une troisième source de tension pour appliquer une troisième tension (Vpass) aux grilles de commande de cellules de mémoire non sélectionnées parmi les cellules de mémoire; et
   - un circuit de commutation pour transférer la troisième tension aux grilles de commande des cellules de mémoire non sélectionnées parmi les cellules de mémoire, en réponse à des signaux de commande, le circuit de commutation faisant passer les grilles de commande dans un état flottant après que toutes les grilles de commande des cellules de mémoire ont été chargées jusqu'à des potentiels prédéterminés et avant que la seconde tension soit appliquée à la plaque conductrice.

4. Mémoire flash selon l'une quelconque des revendications précédentes, dans laquelle le réseau est divisé en une pluralité de blocs de mémoire, et dans laquelle la seconde source de tension applique la seconde tension à la plaque conductrice en réponse à un signal de commande qui sélectionne l'un des blocs de mémoire.

5. Mémoire flash selon la revendication 4 lorsqu'elle dépend des revendications 2 ou 3, dans laquelle les signaux de commande comprennent :

   - un premier signal de commande d'attaque qui fait passer toutes les grilles de commande dans un état flottant après que toutes les grilles de commande ont été chargées jusqu'à des potentiels prédéterminés et avant que la seconde tension soit appliquée à la plaque conductrice, et
   - un second signal de commande d'attaque qui connecte la seconde tension à la plaque conductrice après que toutes les grilles de commande des cellules de mémoire ont été chargées jusqu'aux potentiels prédéterminés.

6. Mémoire flash selon la revendication 1, comprenant en outre :

   le réseau étant divisé en une pluralité de blocs de mémoire, et les grilles de commande des cellules de mémoire étant couplées à des lignes de mots;

   - une pluralité de lignes d'attaque (S0-S15) connectées aux grilles de commande (WL0-WL15) par l'intermédiaire
   - de transistors de transfert correspondants (T2 ∼ T17; T2* ∼ T17*);
   - un décodeur de bloc (170) pour commander les transistors de transfert; et
   - un décodeur de section (120) couplé aux lignes d'attaque; le décodeur de section fournissant la première tension (Vpgm), la seconde tension (Vbp), et fournissant en outre une troisième tension (Vpass) à des lignes de mots non sélectionnées;

dans laquelle la seconde tension est appliquée à la plaque conductrice après que la première tension a été effectivement transférée à la cellule sélectionnée parmi les cellules de mémoire, par l'intermédiaire de la ligne de mots associée.

7.  Mémoire flash selon la revendication 6, comprenant en outre :

    -   une ligne d'attaque supplémentaire (Sb,p) correspondant à la plaque conductrice;
    -   un circuit de commutation incluant un transistor de transfert (T0, T0*) interposé entre une ligne d'attaque et la plaque conductrice, et une pluralité de transistors de transfert (T1 ~ T18; T1* ~ T18*) interposés entre des lignes d'attaque et des lignes de mots correspondantes,
    -   le décodeur de bloc (170) étant couplé à des grilles des transistors de transfert du circuit de commutation, une première sortie du décodeur de bloc (Vp) étant couplée à la grille du transistor de transfert connecté à la plaque conductrice, et une seconde sortie du décodeur de bloc (Vx) étant couplée aux grilles des transistors de transfert connectés aux conducteurs de mots;

    dans laquelle la seconde tension (Vbp) est appliquée à la plaque conductrice, en réponse à un signal de commande qui sélectionne l'un des blocs de mémoire, après que les première et troisième tensions ont été effectivement transférées aux lignes de mots sélectionnées et non sélectionnées.

8.  Procédé pour faire fonctionner une mémoire flash comprenant un réseau de cellules de mémoire (100) ayant des sources, des drains, des grilles flottantes et des grilles de commande, le réseau incluant une plaque conductrice (102) formée sur les cellules de mémoire pour procurer un couplage capacitif (Ca, Cc) entre les cellules de mémoire et la plaque conductrice, et une première source de tension (150); dans lequel

    -   la première source de tension (150) applique une première tension (Vpgm) à la grille de commande (WL) de l'une sélectionnée des cellules de mémoire;

    **caractérisée en ce que** :

    -   les grilles de commande sont placées dans un état flottant après (t4, t7) que la grille de commande (WL) de la cellule sélectionnée parmi les cellules de mémoire a été chargée jusqu'à un potentiel prédéterminé par la première source de tension (150); et
    -   une seconde source de tension (132) incorporée dans la mémoire flash applique une seconde tension (Vbp) à la plaque conductrice après (t5, t8) que les grilles de commande ont été placées dans un état flottant.

9.  Procédé selon la revendication 8, comprenant en outre :

    le transfert de la première tension à une grille de commande (WL) de la cellule sélectionnée parmi les cellules de mémoire, et
    le transfert de la seconde tension (Vbp) à la plaque conductrice, en réponse à un signal de commande.

10. Procédé selon la revendication 8 ou la revendication 9, comprenant en outre :

    la fourniture d'une troisième tension (Vpass); et
    le transfert de la troisième tension aux grilles de commande des cellules de mémoire non sélectionnées parmi les cellules de mémoire, en réponse à des signaux de commande,
    les grilles de commande (WL) étant dans un état flottant après que toutes les grilles de commande des cellules de mémoire ont été chargées jusqu'à des potentiels prédéterminés et avant que la seconde tension soit appliquée à la plaque conductrice.

11. Procédé selon l'une quelconque des revendications 9 ou 10, dans laquelle le réseau est divisé en une pluralité de blocs de mémoire, et la seconde tension est appliquée à la plaque conductrice en réponse à un signal de commande qui sélectionne l'un des blocs de mémoire.

12. Procédé selon la revendication 11 lorsqu'elle dépend de la revendication 10, dans lequel :

les signaux de commande comprennent :

- un premier signal de commande d'attaque qui fait passer toutes les grilles de commande dans un état flottant après que toutes les grilles de commande ont été chargées jusqu'à des potentiels prédéterminés, et avant que la seconde tension soit appliquée à la plaque conductrice, et
- un second signal de commande d'attaque qui connecte la seconde tension à la plaque conductrice après que toutes les grilles de commande des cellules de mémoire ont été chargées jusqu'aux potentiels prédéterminés.

**13.** Procédé selon la revendication 8, comprenant en outre :

la division du réseau en une pluralité de blocs de mémoire, avec le couplage des grilles de commande des cellules de mémoire à des lignes de mots;
la connexion d'une pluralité de lignes d'attaque aux grilles de commande par l'intermédiaire de transistors de transfert et de lignes de mots correspondants;
la commande des transistors de transfert avec un décodeur de bloc; et
le couplage d'un décodeur de section (120) aux lignes d'attaque;
le décodeur de section fournissant la première tension, la seconde tension, et fournissant en outre une troisième tension (Vpass) à des lignes de mots non sélectionnées;

dans lequel la seconde tension est appliquée à la plaque conductrice après que la première tension a été effectivement transférée à celle des lignes de mots qui a été sélectionnée.

**14.** Procédé selon la revendication 13, comprenant en outre :

le couplage d'une ligne d'attaque supplémentaire (Sb,p) à la plaque conductrice (102);
l'incorporation d'un circuit de commutation incluant un transistor de transfert (T0, T0*) interposé entre l'une correspondante des lignes d'attaque et la plaque conductrice, et une pluralité de transistors de transfert (T1 ~ T18; T1* ~ T18*) interposés entre des lignes d'attaque et des lignes de mots correspondantes,
le couplage du décodeur de bloc à des grilles des transistors de transfert du circuit de commutation, une première sortie (Vp) du décodeur de bloc étant couplée à la grille du transistor de transfert connecté à la plaque conductrice, et une seconde sortie (Vx) du décodeur de bloc étant couplée aux grilles des transistors de transfert connectés aux lignes de mots,
l'application de la seconde tension à la plaque conductrice en réponse à un signal de commande qui sélectionne l'un des blocs de mémoire, après que les première et troisième tensions ont été effectivement transférées aux lignes de mots sélectionnées et non sélectionnées.

# Fig.1A

# Fig.1B

# Fig. 2

Booster Plate

Plate—Oxide

Floating Gate

ONO

Control Gate

ONO

Floating Gate

Control Gate

Bit Line

Word Line

# Fig. 3

Vpgm_wl(Vpgm+Vth)

Selected WL(Vpgm),
Booster Plate(Vpgm)

Deselected WL(Vpass)

PROGRAM VOLT SETTING | PROGRAM

EP 0 880 143 B1

# Fig. 4

Block Decoder — 110

Section Decoder — 120

Vpgm pump / Vpass pump — 150, 160

Vx

T0, T18 — 130

Sb.p:Vbp
Sssl:Vcc
S0:Vpgm
S1:Vpass
...
S13:Vpass
S14:Vpass
S15:Vpass
Sgsl:Vss

NU1  NU2  NUn

100  102

SSL:Vcc
Wl0:Vpgm
WL1:Vpass
...
WL13:Vpass
WL14:Vpass
WL15:Vpass
GSL:Vss

SST
M0
M2
M13
M14
M15
GST

BL1  BL2  BLn

Page Buffer — 140

EP 0 880 143 B1

# Fig. 5

# Fig. 6

Boosted Wordline (Calculated)

# Fig. 7

<u>110</u>

# Fig. 8

EP 0 880 143 B1

## Fig. 9

EP 0 880 143 B1

# Fig.10

Vpgm−Vth

[V]

$r_c*$

Selected Word Line

Booster Plate(Vbp)

Unselected Word Lines(Vpass)

t0    t1

[t]

PROGRAM VOLT SETTING    PROGRAM

# Fig.11

<u>110</u>

EP 0 880 143 B1

# Fig.12

# Fig.13

EP 0 880 143 B1

# Fig.14A

Fig.14B

EP 0 880 143 B1

# Fig.15

Vp ——————————————————————— 13V

——————————————————— 13V

Vx ————————————————————— 

————————————————— 11V

Vpgm ——————

—————————————— 5V

Vpass ——————

————————————— 17V

Boosted Voltage of
Selected Word Line ——————  11V

—————————— 12V

Boosted Voltage of
Unselected Word Line ——————  5V

————————— 11V

Sbp ——————————————

t6 t7    t8